# EUROPEAN PATENT APPLICATION

(11) **EP 4 716 446 A2**
(43) Date of publication of application: **25.03.2026**
(21) Application number: 25200843.8
(22) Date of filing: 08.09.2025
(51) Int. Cl.: H10P 74/00, H10W 90/20, H10P 74/20, H10W 90/00

(54) **SEMICONDUCTOR DIES AND SEMICONDUCTOR WAFERS FOR DETECTING MISALIGNMENT OF CHIP BONDING PADS**

(30) Priority: 20.09.2024 KR 20240127545
(71) Applicant: Samsung Electronics Co., Ltd., Suwon-si, Gyeonggi-do 16677 (KR)
(72) Inventor: JUNG, Sanghoon, 16677 Suwon-si (KR); PARK, Youngseok, 16677 Suwon-si (KR); SEO, Younghun, 16677 Suwon-si (KR); YOON, Hyunchul, 16677 Suwon-si (KR)
(74) Representative: Marks & Clerk LLP

(57) **Abstract**

Semiconductor dies and semiconductor wafers are provided. A first semiconductor die, a second semiconductor die, and a detector are configured to determine the degree of alignment accuracy with the first semiconductor die being coupled to the second semiconductor die. First test pads of each of first test pad groups of the first semiconductor die are electrically connected to each other through a line extending in a first direction, and second test pads of each of second test pad groups of the second semiconductor die are electrically connected to each other through a line extending in a third direction transversing the first direction. The detector detects misalignment between the first semiconductor die and the second semiconductor die, based on current flowing between the first test pads of each first test pad group and the second test pads of each second test pad group.

## Description

### BACKGROUND

As semiconductor manufacturing techniques have advanced, various processes for manufacturing semiconductor devices have been developed. One of the processes includes a process of realizing one semiconductor device by coupling two or more semiconductor dies, or realizing a plurality of semiconductor devices by coupling two or more semiconductor wafers. When coupling two or more semiconductor dies or semiconductor wafers, alignment of the semiconductor dies or the semiconductor wafers may be a factor for determining the yield.

When the semiconductor dies or the semiconductor wafers are not successfully aligned, communication between the semiconductor dies or the semiconductor wafers may not be successfully performed. When communication is not successfully performed, (a) semiconductor device(s) realized via coupling may have a defect, and the yield of the semiconductor device(s) may be decreased.

Thus, a method of determining the degree of accuracy of the alignment of semiconductor dies or semiconductor wafers is desired. Furthermore, when it is possible to adjust the coupling of the semiconductor dies or the semiconductor wafers according to a determined misalignment degree, the yield of the semiconductor device(s) may be improved.

### SUMMARY

In general, the present disclosure is directed toward semiconductor dies and semiconductor wafers for detecting misalignment of chip bonding pads.

According to some implementations, the present disclosure is directed to a semiconductor die that includes a first semiconductor die including first test pads, wherein the first test pads are grouped into a plurality of first test pad groups and the first test pads of each of the plurality of first test pad groups are electrically connected to each other through a line in a first direction, a second semiconductor die including second test pads, wherein the second test pads are grouped into a plurality of second test pad groups, the plurality of second test pad groups are arranged at positions respectively corresponding to positions of the plurality of first test pad groups, and the second test pads of each of the plurality of second test pad groups are electrically connected to each other through a line in a third direction crossing the first direction, and a detector configured to determine a degree of accuracy of alignment between the first semiconductor die and the second semiconductor die, based on currents flowing between the first test pads of each of the plurality of first test pad groups and the second test pads of each of the plurality of second test pad groups, when the first semiconductor die and the second semiconductor die are coupled to each other. According to some implementations, the first semiconductor die further comprises first bonding pads, wherein the first bonding metal pads are connected to a cell array structure comprising a plurality of memory blocks, and/or the second semiconductor die further comprises second bonding metal pads in contact with the first bonding metal pads, respectively, wherein the second bonding metal pads are connected to a core core peripheral circuit structure comprising circuits connected to the plurality of memory blocks, respectively.

According to some implementations, the present disclosure is directed to a semiconductor die that includes a first semiconductor die including first bonding metal pads and first test pads, wherein the first bonding metal pads are connected to a cell array structure including a plurality of memory blocks, the first test pads are grouped into a plurality of first test pad groups, and the first test pads of each of the plurality of first test pad groups are electrically connected to each other through a line in a first direction, a second semiconductor die including second bonding metal pads in contact with the first bonding metal pads, respectively, and second test pads, wherein the second bonding metal pads are connected to a core peripheral circuit structure including circuits connected to the plurality of memory blocks, respectively, the second test pads are grouped into a plurality of second test pad groups, the plurality of second test pad groups are arranged at positions respectively corresponding to positions of the plurality of first test pad groups, and the second test pads of each of the plurality of second test pad groups are electrically connected to each other through a line in a third direction crossing the first direction, and a detector configured to determine a degree of accuracy of alignment between the first semiconductor die and the second semiconductor die, based on currents flowing between the first test pads of each of the plurality of first test pad groups and the second test pads of each of the plurality of second test pad groups, when the first semiconductor die and the second semiconductor die are coupled to each other.

According to some implementations, the present disclosure is directed to a semiconductor wafer that includes a first semiconductor wafer including first semiconductor dies arranged in a first direction and a third direction crossing the first direction, wherein each of the first semiconductor dies includes first test pads, the first test pads are grouped into a plurality of first test pad groups, and the first test pads of each of the plurality of first test pad groups are electrically connected to each other through a line in the first direction, a second semiconductor wafer including second semiconductor dies arranged in the first direction and the third direction, wherein each of the second semiconductor dies includes second test pads, the second test pads are grouped into a plurality of second test pad groups, the plurality of second test pad groups are arranged at positions respectively corresponding to positions of the plurality of first test pad groups, and the second test pads of each of the plurality of second test pad groups are electrically connected to each other through a line in the third direction, and a detector configured to determine a degree of accuracy of alignment between the first semiconductor wafer and the second semiconductor wafer, based on currents flowing between the first test pads of each of the plurality of first test pad groups and the second test pads of each of the plurality of second test pad groups, when the first semiconductor wafer and the second semiconductor wafer are coupled to each other.

According to some implementations, the present disclosure is directed to a semiconductor wafer that includes a first semiconductor wafer including first semiconductor dies arranged in a first direction and a third direction crossing the first direction, wherein each of the first semiconductor dies includes first bonding metal pads and first test pads, the first bonding metal pads are connected to a cell array structure including a plurality of memory blocks, the first test pads are grouped into a plurality of first test pad groups, and the first test pads of each of the plurality of first test pad groups are electrically connected to each other through a line in the first direction, a second semiconductor wafer including second semiconductor dies arranged in the first direction and the third direction, wherein each of the second semiconductor dies includes second bonding metal pads respectively in contact with the first bonding metal pads and second test pads, the second bonding metal pads are connected to a core peripheral circuit structure including circuits respectively connected to the plurality of memory blocks, the second test pads are grouped into a plurality of second test pad groups, the plurality of second test pad groups are arranged at positions respectively corresponding to positions of the plurality of first test pad groups, and the second test pads of each of the plurality of second test pad groups are electrically connected to each other through a line in a third direction crossing the first direction, and a detector configured to determine a degree of accuracy of alignment between the first semiconductor wafer and the second semiconductor wafer, based on currents flowing between the first test pads of each of the plurality of first test pad groups and the second test pads of each of the plurality of second test pad groups, when the first semiconductor wafer and the second semiconductor wafer are coupled to each other.

While a third direction is described, the third direction may be referred to as a second direction. Similarly, the naming convention of other direction may be re-ordered. For example, a second direction may be referred to as a third direction. First and third (or second) directions may extend along a first axis, e.g., x axis. Second (or third) and fourth directions may extend along a second axis, e.g., a y axis. The first and second axis may be perpendicular to each other.

At least some of the above and other features of the disclosure are set out in the claims.

### BRIEF DESCRIPTION OF THE DRAWINGS

Example implementations will be more clearly understood from the following detailed description, taken in conjunction with the accompanying drawings.
FIG. 1 illustrates examples of a first semiconductor wafer and a second semiconductor wafer according to some implementations.
FIG. 2 illustrates an example in which one first die is coupled to one second die of FIG. 1 according to some implementations.
FIGS. 3A and 3B illustrate examples of components of the first die and the second die of FIG. 2 according to some implementations.
FIGS. 4A to 4B are views showing an example of a state in which the first die is coupled to the second die of FIG. 3A according to some implementations. Figure 4C is a circuit diagram of a detector according to some implementations.
FIGS. 5A to 5D are views showing an example of test pad patterns according to some implementations.
FIGS. 6 to 9 are views showing an example of a semiconductor device according to some implementations.
FIG. 10 is a block diagram of an example of a system to describe an electronic device including a semiconductor device according to some implementations.

### DETAILED DESCRIPTION

Hereinafter, example implementations will be explained in detail with reference to the accompanying drawings.

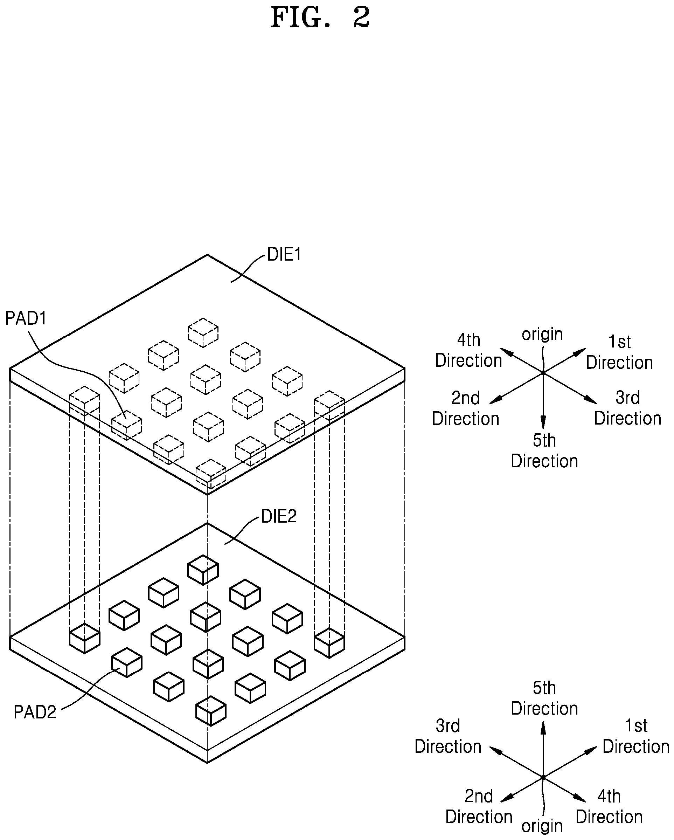

In some implementations, a semiconductor device may use a three-dimensional (3D) stack technique. The 3D stack technique has been proposed as a solution to overcome the scaling limits by providing many virtues including a high capacity, a high band width, low power consumption, and low form-factors. A 3D semiconductor device may use a through-silicon-via (TSV) method in which a silicon via passes through each of semiconductor dies to electrically connect semiconductor chips. A first die and a second die that are stacked in a vertical direction may be provided (see FIG. 2). First TSVs passing through the first die may be formed, first pads may be formed below the first TSVs, and the first pads may be formed on a surface of a substrate of the first die adjacent to the second die. Second TSVs passing through the second die may be formed, second pads may be formed above the second TSVs, and the second pads may be formed on a surface of a substrate of the second die adjacent to the first die. When the first die and the second die are coupled to each other, the first pads and the second pads may be coupled to each other. When positions of the first pads are accurately aligned with positions of the second pads (for example, aligned within a permissible error range), the coupling of the first die and the second die may be successful. When positions of the first pads are not accurately aligned with positions of the second pads (for example, aligned beyond a permissible error range), the coupling of the first die and the second die may fail. Hereinafter, there is provided a semiconductor wafer for supporting a test operation for determining the degree of accuracy of alignment of the first pads and the second pads and adjusting the coupling of the first die and the second die according to a determined degree of misalignment.

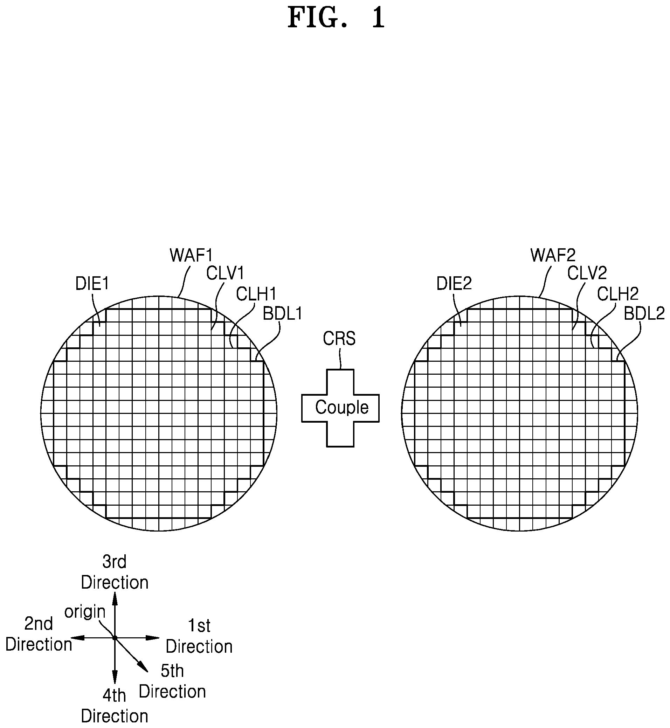

FIG. 1 illustrates examples of a first semiconductor wafer and a second semiconductor wafer according to some implementations. In FIG. 1, first semiconductor dies DIE1 may be manufactured, within a first boundary line BDL1, on a first semiconductor wafer WAF1 corresponding to a fifth direction. By cutting the first semiconductor wafer WAF1 along a first horizontal cutting line CLH1 corresponding to a first direction and a second direction and a first vertical cutting line CLV1 corresponding to a third direction and a fourth direction, the first semiconductor dies DIE1 may be separated from the first semiconductor wafer WAF1. Second semiconductor dies DIE2 may be manufactured, within a second boundary line BDL2, on a second semiconductor wafer WAF2 corresponding to the fifth direction. By cutting the second semiconductor wafer WAF2 along a second horizontal cutting line CLH2 corresponding to the first direction and the second direction and a second vertical cutting line CLV2 corresponding to the third direction and the fourth direction, the second semiconductor dies DIE2 may be separated from the second semiconductor wafer WAF2.

As indicated by a cross CRS in FIG. 1, the first semiconductor wafer WAF1 and the second semiconductor wafer WAF2 may be coupled to each other to realize a plurality of semiconductor devices. After coupling the first semiconductor wafer WAF1 and the second semiconductor wafer WAF2 to each other, the resultant object may be cut to obtain the plurality of semiconductor devices in which the first semiconductor dies DIE1 and the second semiconductor dies DIE2 are coupled to each other. For convenience of explanation, the first semiconductor dies DIE1 may be referred to as first dies, and the second semiconductor dies DIE2 may be referred to as second dies.

According to some implementations, the plurality of semiconductor devices may include a memory device and/or a logic semiconductor device. For example, the memory device may include a volatile memory device, such as dynamic random-access memory (DRAM), static random-access memory (SRAM), mobile DRAM, double data rate (DDR) synchronous DRAM (SDRAM), low power DDR (LPDDR) SDRAM, graphic DDR (GDDR) SDRAM, rambus DRAM (RDRAM), and a high bandwidth memory (HBM) device. In some implementations, the memory device may include a non-volatile memory device, such as electrically erasable programmable read-only memory (EEPROM), flash memory, phase change random-access memory (PRAM), resistance random-access memory (RRAM), nano floating gate memory (NFGM), polymer random-access memory (PoRAM), magnetic random-access memory (MRAM), ferroelectric random-access memory (FRAM), etc. The logic semiconductor device may include a central processing unit (CPU), a graphics processing unit (GPU), a neural processing unit (NPU), an application processor (AP), a system-on-chip (SoC), etc. The logic semiconductor device may be realized as an application specific integrated circuit (ASIC), an SoC, etc.

FIG. 2 illustrates an example in which one first die is coupled to one second die of FIG. 1 according to some implementations. In FIGS. 1 and 2, in order to be coupled to a second die DIE2, a first die DIE1 may be rotated by 180 degrees with respect to the first direction and the second direction. Accordingly, a coordinate system of the first die DIE1 and a coordinate system of the second die DIE2 may be separately indicated from each other. The first die DIE1 may include first pads PAD1 arranged on an upper surface in the fifth direction. The first pads PAD1 may be arranged and/or separated from each other in the first direction and the third direction at equal intervals. The second die DIE2 may include second pads PAD2 arranged on an upper surface in the fifth direction. The second pads PAD2 may also be arranged and/or separated from each other in the first direction and the third direction at equal intervals.

When the first semiconductor wafer WAF1 is coupled to the second semiconductor wafer WAF2, the first pads PAD1 of the first die DIE1 may be coupled (sometimes, referred to as bonded) to the second pads PAD2 of the second die DIE2. When positions of the first pads PAD1 are accurately aligned with positions of the second pads PAD2 (for example, aligned within a permissible error range), the coupling may succeed. When the positions of the first pads PAD1 are not accurately aligned with the positions of the second pads PAD2 (for example, aligned beyond the permissible error range), the coupling may not succeed.

The semiconductor dies and the semiconductor wafers may support a test operation for determining the degree of alignment accuracy. The semiconductor dies and the semiconductor wafers may provide test pads used for an alignment test operation. By performing the alignment test operation, the semiconductor dies and the semiconductor wafers may be easily and accurately aligned and coupled.

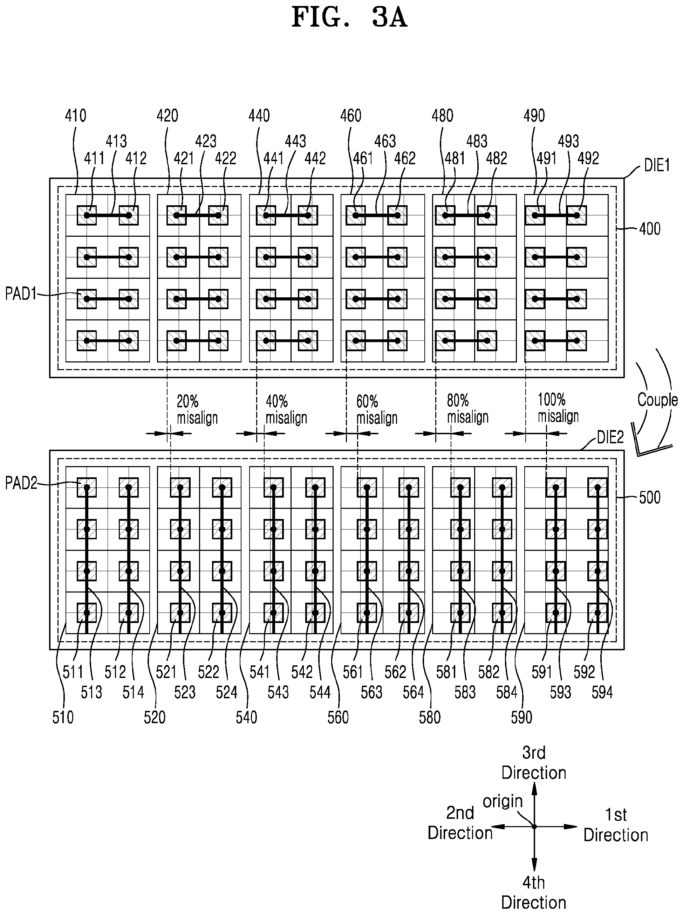

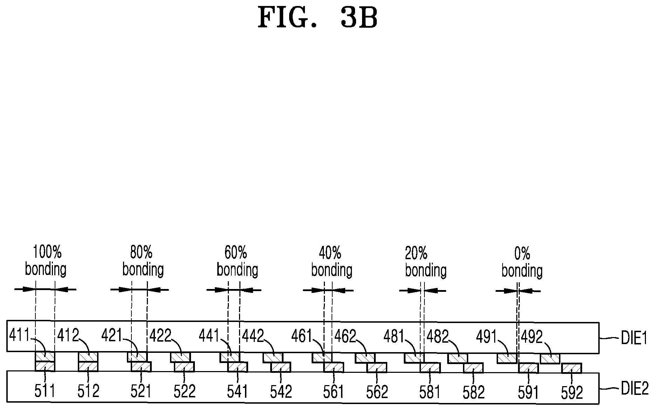

FIGS. 3A and 3B illustrate examples of components of the first die DIE1 and the second die DIE2 of FIG. 2 according to some implementations. FIG. 3A shows test pads, namely, first to sixth test pads 411, 412, 421, 422, 441, 442, 461, 462, 481, 482, 491, 492, 511, 512, 521, 522, 541, 542, 561, 562, 581, 582, 591, and 592, for determining the degree of alignment accuracy when the first pads PAD1 of the first die DIE1 are coupled to the second pads PAD2 of the second die DIE2. FIG. 3B shows a coupling state according to the first to sixth test pads 411, 412, 421, 422, 441, 442, 461, 462, 481, 482, 491, 492, 511, 512, 521, 522, 541, 542, 561, 562, 581, 582, 591, and 592 of FIG. 3A.

In FIG. 3A, the first die DIE1 may include a first test pad pattern 400, and the second die DIE2 may include a second test pad pattern 500. The first test pad pattern 400 may include a plurality of test pad groups, namely, first to sixth test pad groups 410, 420, 440, 460, 480, and 490, into which the first to sixth test pads 411, 412, 421, 422, 441, 442, 461, 462, 481, 482, 491, and 492 are grouped. The first test pad pattern 400 may be a particular (e.g., a first) arrangement of the respective test pad groups 410, 420, 440, 460, 480, 490 on the first die DIE1. The second test pad pattern 500 may include a plurality of test pad groups, namely, first to sixth test pad groups 510, 520, 540, 560, 580, and 590, into which the first to sixth test pads 511, 512, 521, 522, 541, 542, 561, 562, 581, 582, 591, and 592 are grouped. The second test pad pattern 500 may be a particular (e.g., a second) arrangement of the respective test pad groups 510, 520, 540, 560, 580, 590 on the first die DIE2. The first to sixth test pad groups 410, 420, 440, 460, 480, and 490 of the first test pad pattern 400 may be respectively arranged at positions respectively corresponding to positions of the first to sixth test pad groups 510, 520, 540, 560, 580, and 590 of the second test pad pattern 500. The first to sixth test pads groups 410, 420, 440, 460, 480, and 490 of the first test pad pattern 400 may be arranged at positions respectively corresponding to positions of the first to sixth test pad groups 510, 520, 540, 560, 580, and 590 in the x-y plane, i.e., in the 1^{st} and 2^{nd}, and 3^{rd} and 4^{th} directions.

The first test pad group 410 of the first test pad pattern 400 may include the first test pads 411 and 412, and the first test pads 411 and 412 may be electrically connected to each other through a line 413. The first test pad 411 may be electrically connected to the second test pad 412 through the line 413. The line 413 may extend in the first direction and/or the second direction. The first pads 411 may be arranged in the third and/or fourth directions, i.e., in a column extending in the third and/or fourth directions. The second pads 412 may be arranged in the third and/or fourth directions, i.e., in a column extending in the third and/or fourth directions. The first and second pads 411, 412 may be arranged adjacent each other in the first and/or second directions, i.e., adjacent columns. The first test pad group 510 of the second test pad pattern 500 may include the first test pads 511 and 512, and the first test pads 511 may be electrically connected to each other through a line 513 and the first test pads 512 may be electrically connected to each other through a line 514. A first test pad 511 may be electrically connected to another first test pad 511 (not labelled in FIG. 3B) through the line 513. The first test pads 511 may be adjacent in the third direction and/or the fourth direction. A second test pad 512 may be electrically connected to another second test pad 512 (not labelled in FIG. 3B) through the line 514. The second test pads 512 may be adjacent in the third direction and/or the fourth direction. The line 513 may extend in the third direction and/or the fourth direction. The line 514 may extend in the third direction and /or the fourth direction. The first pads 511 may be arranged in the third and/or fourth directions, i.e., in a column extending in the third and/or fourth directions. The second pads 512 may be arranged in the third and/or fourth directions, i.e., in a column extending in the third and/or fourth directions. The first and second pads 511, 512 may be arranged adjacent each other in the first and/or second directions, i.e., adjacent columns.

The first test pads 411 and 412 of the first die DIE1 may be coupled to the first test pads 511 and 512 of the second die DIE2. The first test pad groups 410 and 510 may be provided to have a shape of no misalignment between the first test pads 411 and 412 of the first die DIE1 and the first test pads 511 and 512 of the second die DIE2, that is, a shape of 0% misalignment. Accordingly, in FIG. 3B, when the first die DIE1 is coupled to the second die DIE2, the first test pads 411 and 412 may be coupled to the first test pads 511 and 512, respectively, with a 100% bonding area. The first test pads 411, 412, and the first test pads 511, 512 may be positioned or arranged on the respective first die DIE1 and second die DIE 2 such that there is no misalignment between the first test pads 411, 412 of the first die DIE1 and the first test pads 511, 512 of the second die DIE2 when the first die DIE1 is coupled to the second die DIE2. No misalignment may be the same as perfect alignment or a bonding area of 100% between the respect pads.

The second test pad group 420 of the first test pad pattern 400 may include the second test pads 421 and 422, and the second test pads 421 and 422 may be electrically connected to each other through a line 423. The second test pad group 520 of the second test pad pattern 500 may include the second test pads 521 and 522, and the second test pads 521 may be electrically connected to each other through a line 523 and the second test pads 522 may be electrically connected to each other through a line 524. The second test pads 421 and 422 of the first die DIE1 may be coupled to the second test pads 521 and 522 of the second die DIE2. The second test pad groups 420 and 520 may be provided to have a shape of 20% misalignment between the second test pads 421 and 422 of the first die DIE1 and the second test pads 521 and 522 of the second die DIE2. Accordingly, in FIG. 3B, when the first die DIE1 is coupled to the second die DIE2, the second test pads 421 and 422 may be coupled to the second test pads 521 and 522, respectively, with an 80% bonding area. The lines 423, 523, 524 may be arranged similarly to the described lines 413, 513, 514, respectively.

The third test pad group 440 of the first test pad pattern 400 may include the third test pads 441 and 442, and the third test pads 441 and 442 may be electrically connected to each other through a line 443. The third test pad group 540 of the second test pad pattern 500 may include the third test pads 541 and 542, and the third test pads 541 may be electrically connected to each other through a line 543 and the third test pads 542 may be electrically connected to each other through a line 544. The lines 443, 543, 544 may be arranged similarly to the described lines 413, 513, 514, respectively. The third test pads 441 and 442 of the first die DIE1 may be coupled to the third test pads 541 and 542 of the second die DIE2. The third test pad groups 440 and 540 may be provided to have a shape of 40% misalignment between the third test pads 441 and 442 of the first die DIE1 and the third test pads 541 and 542 of the second die DIE2. Accordingly, in FIG. 3B, when the first die DIE1 is coupled to the second die DIE2, the third test pads 441 and 442 may be coupled to the third test pads 541 and 542, respectively, with a 60% bonding area.

The fourth test pad group 460 of the first test pad pattern 400 may include the fourth test pads 461 and 462, and the fourth test pads 461 and 462 may be electrically connected to each other through a line 463. The fourth test pad group 560 of the second test pad pattern 500 may include the fourth test pads 561 and 562, and the fourth test pads 561 may be electrically connected to each other through a line 563 and the fourth test pads 562 may be electrically connected to each other through a line 564. The lines 463, 563, 564 may be arranged similarly to the described lines 413, 513, 514, respectively. The fourth test pads 461 and 462 of the first die DIE1 may be coupled to the fourth test pads 561 and 562 of the second die DIE2. The fourth test pad groups 460 and 560 may be provided to have a shape of 60% misalignment between the fourth test pads 461 and 462 of the first die DIE1 and the fourth test pads 561 and 562 of the second die DIE2. Accordingly, in FIG. 3B, when the first die DIE1 is coupled to the second die DIE2, the fourth test pads 461 and 462 may be coupled to the fourth test pads 561 and 562, respectively, with a 40% bonding area.

The fifth test pad group 480 of the first test pad pattern 400 may include the fifth test pads 481 and 482, and the fifth test pads 481 and 482 may be electrically connected to each other through a line 483. The fifth test pad group 580 of the second test pad pattern 500 may include the fifth test pads 581 and 582, and the fifth test pads 581 may be electrically connected to each other through a line 583 and the fifth test pads 582 may be electrically connected to each other through a line 584. The lines 483, 583, 584 may be arranged similarly to the described lines 413, 513, 514, respectively. The fifth test pads 481 and 482 of the first die DIE1 may be coupled to the fifth test pads 581 and 582 of the second die DIE2. The fifth test pad groups 480 and 580 may be provided to have a shape of 80% misalignment between the fifth test pads 481 and 482 of the first die DIE1 and the fifth test pads 581 and 582 of the second die DIE2. Accordingly, in FIG. 3B, when the first die DIE1 is coupled to the second die DIE2, the fifth test pads 481 and 482 may be coupled to the fifth test pads 581 and 582, respectively, with a 20% bonding area.

The sixth test pad group 490 of the first test pad pattern 400 may include the sixth test pads 491 and 492, and the sixth test pads 491 and 492 may be electrically connected to each other through a line 493. The sixth test pad group 590 of the second test pad pattern 500 may include the sixth test pads 591 and 592, and the sixth test pads 591 may be electrically connected to each other through a line 593 and the sixth test pads 592 may be electrically connected to each other through a line 594. The lines 493, 593, 594 may be arranged similarly to the described lines 413, 513, 514, respectively. The sixth test pads 491 and 492 of the first die DIE1 may be coupled to the sixth test pads 591 and 592 of the second die DIE2. The sixth test pad groups 490 and 590 may be provided to have a shape of 100% misalignment between the sixth test pads 491 and 492 of the first die DIE1 and the sixth test pads 591 and 592 of the second die DIE2. Accordingly, in FIG. 3B, when the first die DIE1 is coupled to the second die DIE2, the sixth test pads 491 and 492 may be coupled to the sixth test pads 591 and 592, respectively, with a 0% bonding area, that is, the sixth test pads 491, 492, 591, and 592 may be in an open state. The described lines 413, 423, 443, 463, 483, 493, 513, 514, 523, 524, 543, 544, 563, 564, 583, 584, 593, 594 may be electrical connections (e.g., wires or traces) between the respective pads.

With respect to the first test pad pattern 400 and the second test pad pattern 500, an example is described, in which the first to sixth test pad groups 410 and 510, 420 and 520, 440 and 540, 460 and 560, 480 and 580, and 490 and 590 are designed (i.e., the test pads within the groups are positioned or arranged) to have the 0%, 20%, 40%, 60%, 80%, and 100% patterns 400, 500 or misalignment shapes, respectively. That is, the difference between corresponding two of the misalignment shapes is 20%, so that the bonding areas of the first to sixth test pads 411, 412, 511, and 512, 421, 422, 521, and 522, 441, 442, 541, and 542, 461, 462, 561, and 562, 481, 482, 581, and 582, and 491, 492, 591, and 592 may be 100%, 80%, 60%, 40%, 20%, and 0%, respectively. The result of the specific test pad patterns 400, 500 of the respective groups on the dies DIE1, DIE2 may be particular misalignment shapes or patterns of the pads when the dies DIE1, DIE2 are coupled to each other. A misalignment shape or pattern may have a set or desired bonding area between the respective pads within a group. For example, pads in a first group across the dies may have a bonding area of 100%, while pads in a second group across the dies may have a bonding area of 80%. Each group of pads may have its own misalignment pattern across the dies when the dies are coupled to each other. However, the example is only given to help understand the present disclosure and is not intended to limit the present disclosure. According to some implementations, the first test pad pattern 400 and the second test pad pattern 500 may be designed to have misalignment shapes, the difference between corresponding two of which is further reduced (for example, 1%, 5%, or 10%), so that the bonding areas of the first to sixth test pads 411, 412, 511, and 512, 421, 422, 521, and 522, 441, 442, 541, and 542, 461, 462, 561, and 562, 481, 482, 581, and 582, and 491, 492, 591, and 592 may be further specified. This may indicate that the accuracy of alignment may be increased according to precise misalignment shapes. According to some embodiments, the difference between corresponding two of the misalignment shapes is not limited to the example differences described above and may be any other difference.

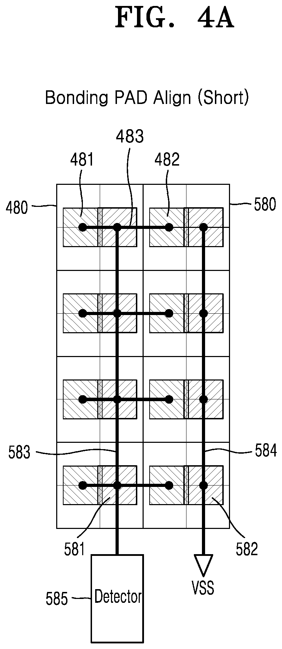

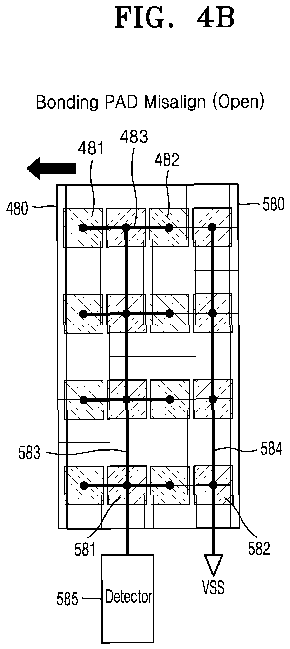

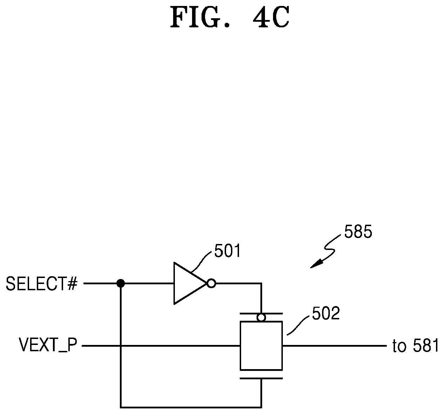

FIGS. 4A to 4C are views to describe a state in which the first die DIE1 is coupled to the second die DIE2 of FIG. 3A according to some implementations. FIG. 4A shows a state in which, when the first die DIE1 is coupled to the second die DIE2, the fifth test pads 481, 482, 581, and 582 of the fifth test pad groups 480 and 580 are accurately aligned, and FIG. 4B shows a state in which the fifth test pads 481, 482, 581, and 582 of the fifth test pad groups 480 and 580 are misaligned. FIG. 4C is a circuit diagram of a detector 585 configured to detect whether or not the fifth test pads 481, 482, 581, and 582 of the fifth test pad groups 480 and 580 are misaligned.

In FIGS. 3A and 4A, the fifth test pads 481 and 482 of the fifth test pad groups 480 of the first die DIE1 may be coupled to the fifth test pads 581 and 582 of the fifth test pad group 580 of the second die DIE2 as the 80% misalignment shape. Accordingly, the fifth test pads 481, 482, 581, and 582 may be coupled to each other with the 20% bonding area and may be electrically connected to each other, that is, may be short-circuited, by the lines 483, 583, and 584.

In FIG. 4B, compared with FIG. 4A, the fifth test pads 481 and 482 of the fifth test pad group 480 of the first die DIE1 may not be coupled to the fifth test pads 581 and 582 of the fifth test pad group 580 of the second die DIE2. This may indicate that the positions of the fifth test pads 481 and 482 of the first die DIE1 are misaligned with the positions of the fifth test pads 581 and 582 of the second die DIE2 by 20% or higher so as to be misaligned by 100% to be in an electrically open state.

In FIG. 4C, the detector 585 may be arranged in the second die DIE2 and may be electrically connected to the fifth test pad 581 of the second die DIE2. The detector 585 may include an inverter 501 configured to receive a selection signal SELECT# and a transmission gate (sometimes referred to as a switch) 502 configured to provide a power voltage VEXT_P to the fifth test pad 581 of the fifth test pad group 580 in response to an output signal and the selection signal SELECT# of the inverter 501. The selection signal SELECT# may command an operation of detecting whether or not there is misalignment with respect to each of the first to sixth test pad groups 410 and 510, 420 and 520, 440 and 540, 460 and 560, 480 and 580, and 490 and 590. The selection signal SELECT# of FIG. 4C may be configured to command an operation of detecting whether or not there is misalignment with respect to the fifth test pads 481, 482, 581, and 582 of the fifth test pad groups 480 and 580. The power voltage VEXT_P may be a power voltage of the second die DIE2.

In FIG. 4A, the detector 585 may be electrically connected to the fifth test pad 581 of the fifth test pads 581 and 582 of the fifth test pad group 580, and a ground voltage line may be connected to the fifth test pad 582. When the selection signal SELECT# is activated as a logic high level, the detector 585 may provide the power voltage VEXT_P to the fifth test pad 581. The fifth test pads 481, 482, 581, and 582 of FIG. 4A may be coupled to each other and electrically connected to each other, that is, short-circuited, by the lines 483, 583, and 584, and thus, the detector 585 may detect currents flowing from the power voltage VEXT_P to a ground voltage VSS. Accordingly, the detector 585 may determine that the fifth test pads 481, 482, 581, and 582 of the fifth test pad groups 480 and 580 may be aligned as the 80% misalignment shape, which is originally designed.

In FIG. 4B, the fifth test pads 481, 482, 581, and 582 of the fifth test pad groups 480 and 580 may be 100% misaligned, that is, in an electrically open state, and the detector 585 may not detect currents flowing from the power voltage VEXT_P to the ground voltage VSS. Accordingly, the detector 585 may determine that the fifth test pads 481, 482, 581, and 582 of the fifth test pad groups 480 and 580 may be misaligned further by 20% or higher from the 80% misalignment shape that is originally designed, so as to be misaligned by 100% to be in the electrically open state. Here, the detector 585 may determine that the coupling of the first die DIE1 and the second die DIE2 may have misalignment of about 20%, and may correct the misalignment of about 20% for the first die DIE1 to be coupled to the second die DIE2. For example, the detector 585 may be configured to implement or instruct one or more error correction algorithms to correct and/or mitigate the effects of the misalignment. The detector 585 may be configured to adjust placement of the pads based on the determined misalignment to correct the misalignment.

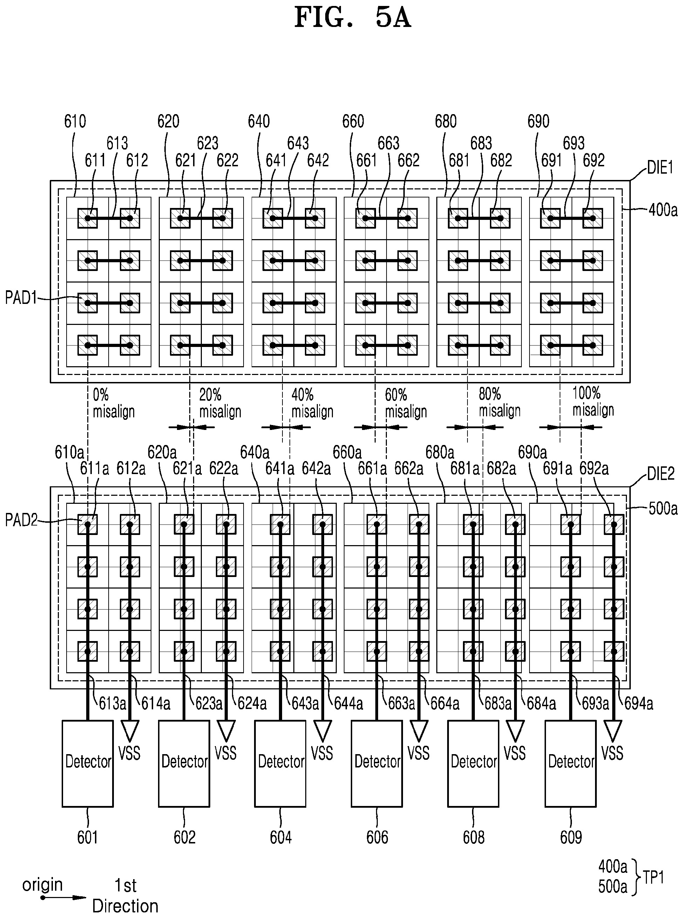

FIGS. 5A to 5D are views to describe first test pad patterns 400a to 400d and second test pad patterns 500a to 500d according to some implementations. Hereinafter, subscripts attached to the same reference numeral in different drawings (for example, a of 400a and b of 400b) are used to distinguish a plurality of components having substantially the same or same functions from one another. The aspects of the first test pad patterns 400a to 400d and the second test pad patterns 500a to 500d that are the same as the aspects of the first and second test pad patterns 400 and 500 of FIG. 3A are not repeatedly described.

In FIG. 5A, in connection with FIG. 3A, the first test pad pattern 400a of the first die DIE1 may include first to sixth test pad groups 610, 620, 640, 660, 680, and 690, and the second test pad pattern 500a of the second die DIE2 may include first to sixth test pad groups 610a, 620a, 640a, 660a, 680a, and 690a. In the first test pad pattern 400a and the second test pad pattern 500a, the first test pad groups 610 and 610a, the second test pad groups 620 and 620a, the third test pad groups 640 and 640a, the fourth test pad groups 660 and 660a, the fifth test pad groups 680 and 680a, and the sixth test pad groups 690 and 690a may be designed to have 0%, 20%, 40%, 60%, 80%, and 100% misalignment shapes, respectively, in a first direction with respect to the origin point, that is, the difference between corresponding two of the misalignment shapes is 20%. In one example, the sizes of the misalignment patterns corresponding to the misalignment shapes may increase in one direction (e.g., only as an example, one of a first direction, a second direction, a third direction, and a fourth direction), and the bonding areas between the test pads of the first test pad pattern 400a and the corresponding test pads of the second test pad pattern 500a may decrease. The first test pad pattern 400a and the second test pad pattern 500a may be referred to as a first test pattern TP1. A size of the misalignment pattern may be defined as a degree of misalignment between test pads in groups of test pads when dies are coupled to each other. In this way, 20% misalignment (i.e., 80% bonding area) may represent a smaller misalignment size than a 40% misalignment (i.e., 60% bonding area). A size of the misalignment (or degree of misalignment) between test pad groups on a first and second dies may increase in a direction, e.g., first direction, third direction, etc. A size of the bonding area between test pads of the respective test pad groups on the first and second dies may decrease in a direction, e.g., first direction, third direction, etc.

The first test pad group 610 of the first test pad pattern 400a may include first test pads 611 and 612, and the first test pads 611 and 612 may be electrically connected to each other through a line 613. The first test pad group 610a of the second test pad pattern 500a may include first test pads 611a and 612a, and the first test pads 611a may be electrically connected to each other through a line 613a and the first test pads 612a may be electrically connected to each other through a line 614a. The first test pad groups 610 and 610a may be provided to have a shape of no misalignment between the first test pads 611 and 612 of the first die DIE1 and the first test pads 611a and 612a of the second die DIE2 in the first direction with respect to the origin point, that is, a shape of 0% misalignment. A detector 601 may be electrically connected to the first test pad 611a of the first test pads 611a and 612a of the second die DIE2, and a ground voltage line may be connected to the first test pad 612a. The detector 601 may detect whether or not the first test pads 611 and 612 of the first test pad group 610 are misaligned with the first test pads 611a and 612a of the first test pad group 610a.

The second test pad group 620 of the first test pad pattern 400a may include second test pads 621 and 622, and the second test pads 621 and 622 may be electrically connected to each other through a line 623. The second test pad group 620a of the second test pad pattern 500a may include second test pads 621a and 622a, and the second test pads 621a may be electrically connected to each other through a line 623a and the second test pads 622a may be electrically connected to each other through a line 624a. The second test pad groups 620 and 620a may be provided to have a shape of 20% misalignment between the second test pads 621 and 622 of the first die DIE1 and the second test pads 621a and 622a of the second die DIE2 in the first direction with respect to the origin point. A detector 602 may be electrically connected to the second test pad 621a of the second test pads 621a and 622a of the second die DIE2, and a ground voltage line may be connected to the second test pad 622a. The detector 602 may detect whether or not the second test pads 621 and 622 of the second test pad group 620 are misaligned with the second test pads 621a and 622a of the second test pad group 620a.

The third test pad group 640 of the first test pad pattern 400a may include third test pads 641 and 642, and the third test pads 641 and 642 may be electrically connected to each other through a line 643. The third test pad group 640a of the second test pad pattern 500a may include third test pads 641a and 642a, and the third test pads 641a may be electrically connected to each other through a line 643a and the third test pads 642a may be electrically connected to each other through a line 644a. The third test pad groups 640 and 640a may be provided to have a shape of 40% misalignment between the third test pads 641 and 642 of the first die DIE1 and the third test pads 641a and 642a of the second die DIE2 in the first direction with respect to the origin point. A detector 604 may be electrically connected to the third test pad 641a of the third test pads 641a and 642a of the second die DIE2, and a ground voltage line may be connected to the third test pad 642a. The detector 604 may detect whether or not the third test pads 641 and 642 of the first test pad group 640 are misaligned with the third test pads 641a and 642a of the first test pad group 640a.

The fourth test pad group 660 of the first test pad pattern 400a may include fourth test pads 661 and 662, and the fourth test pads 661 and 662 may be electrically connected to each other through a line 663. The fourth test pad group 660a of the second test pad pattern 500a may include fourth test pads 661a and 662a, and the fourth test pads 661a may be electrically connected to each other through a line 663a and the fourth test pads 662a may be electrically connected to each other through a line 664a. The fourth test pad groups 660 and 660a may be provided to have a shape of 60% misalignment between the fourth test pads 661 and 662 of the first die DIE1 and the fourth test pads 661a and 662a of the second die DIE2 in the first direction with respect to the origin point. A detector 606 may be electrically connected to the fourth test pad 661a of the fourth test pads 661a and 662a of the second die DIE2, and a ground voltage line may be connected to the fourth test pad 662a. The detector 606 may detect whether or not the fourth test pads 661 and 662 of the fourth test pad group 660 are misaligned with the fourth test pads 661a and 662a of the fourth test pad group 660a.

The fifth test pad group 680 of the first test pad pattern 400a may include fifth test pads 681 and 682, and the fifth test pads 681 and 682 may be electrically connected to each other through a line 683. The fifth test pad group 680a of the second test pad pattern 500a may include fifth test pads 681a and 682a, and the fifth test pads 681a may be electrically connected to each other through a line 683a and the fifth test pads 682a may be electrically connected to each other through a line 684a. The fifth test pad groups 680 and 680a may be provided to have a shape of 80% misalignment between the fifth test pads 681 and 682 of the first die DIE1 and the fifth test pads 681a and 682a of the second die DIE2 in the first direction with respect to the origin point. A detector 608 may be electrically connected to the fifth test pad 681a of the fifth test pads 681a and 682a of the second die DIE2, and a ground voltage line may be connected to the fifth test pad 682a. The detector 608 may detect whether or not the fifth test pads 681 and 682 of the fifth test pad group 680 are misaligned with the fifth test pads 681a and 682a of the fifth test pad group 680a.

The sixth test pad group 690 of the first test pad pattern 400a may include sixth test pads 691 and 692, and the sixth test pads 691 and 692 may be electrically connected to each other through a line 693. The sixth test pad group 690a of the second test pad pattern 500a may include sixth test pads 691a and 692a, and the sixth test pads 691a may be electrically connected to each other through a line 693a and the sixth test pads 692a may be electrically connected to each other through a line 694a. The sixth test pad groups 690 and 690a may be provided to have a shape of 100% misalignment between the sixth test pads 691 and 692 of the first die DIE1 and the sixth test pads 691a and 692a of the second die DIE2 in the first direction with respect to the origin point. A detector 609 may be electrically connected to the sixth test pad 691a of the sixth test pads 691a and 692a of the second die DIE2, and a ground voltage line may be connected to the sixth test pad 692a. The detector 609 may detect whether or not the sixth test pads 691 and 692 of the sixth test pad group 690 are misaligned with the sixth test pads 691a and 692a of the sixth test pad group 690a.

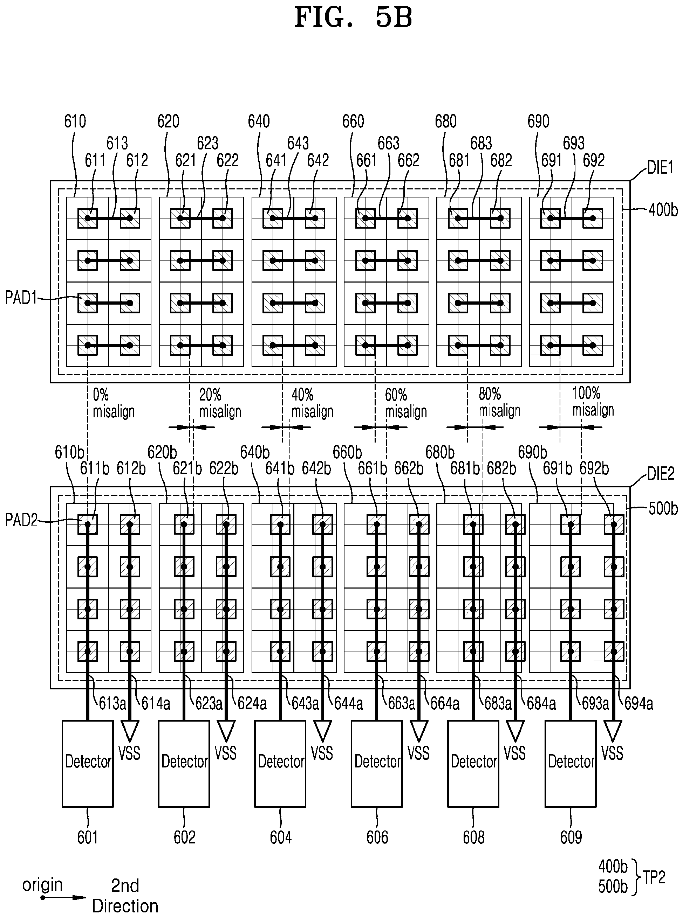

In FIG. 5B, a second test pattern TP2 including the first test pad pattern 400b of the first die DIE1 and the second test pad pattern 500b of the second die DIE2 may be different from the first test pattern TP1 of FIG. 5A in that first test pad groups 610 and 610b, second test pad groups 620 and 620b, third test pad groups 640 and 640b, fourth test pad groups 660 and 660b, fifth test pad groups 680 and 680b, and sixth test pad groups 690 and 690b may be designed to have 0%, 20%, 40%, 60%, 80%, and 100% misalignment shapes, respectively, in a second direction with respect to the origin point, that is, the difference between corresponding two of the misalignment shapes is 20%.

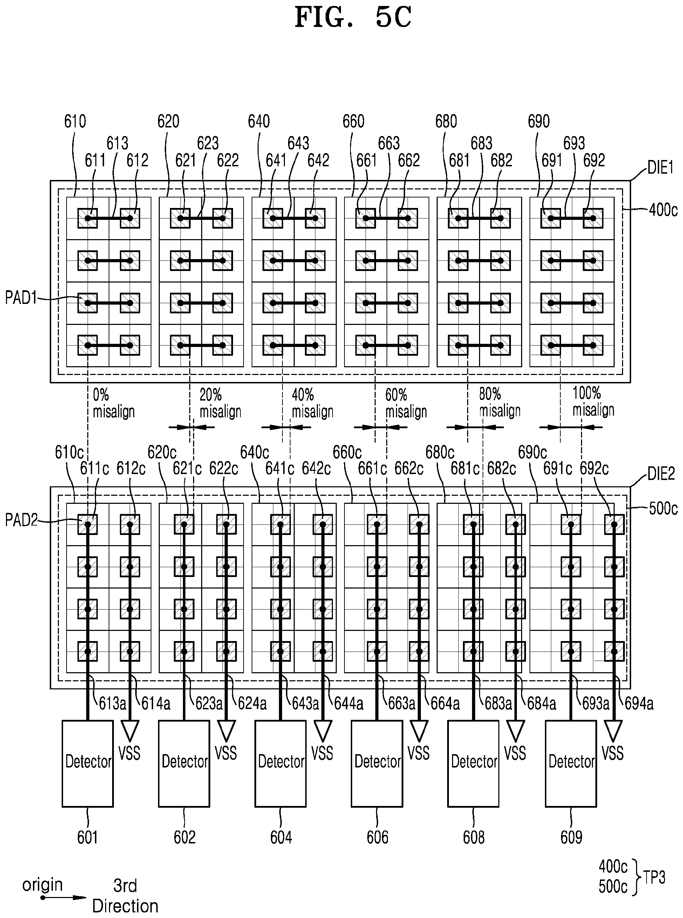

In FIG. 5C, a third test pattern TP3 including the first test pad pattern 400c of the first die DIE1 and the second test pad pattern 500c of the second die DIE2 may be different from the first test pattern TP1 of FIG. 5A in that first test pad groups 610 and 610c, second test pad groups 620 and 620c, third test pad groups 640 and 640c, fourth test pad groups 660 and 660c, fifth test pad groups 680 and 680c, and sixth test pad groups 690 and 690c may be designed to have 0%, 20%, 40%, 60%, 80%, and 100% misalignment shapes, respectively, in a third direction with respect to the origin point, that is, the difference between corresponding two of the misalignment shapes is 20%.

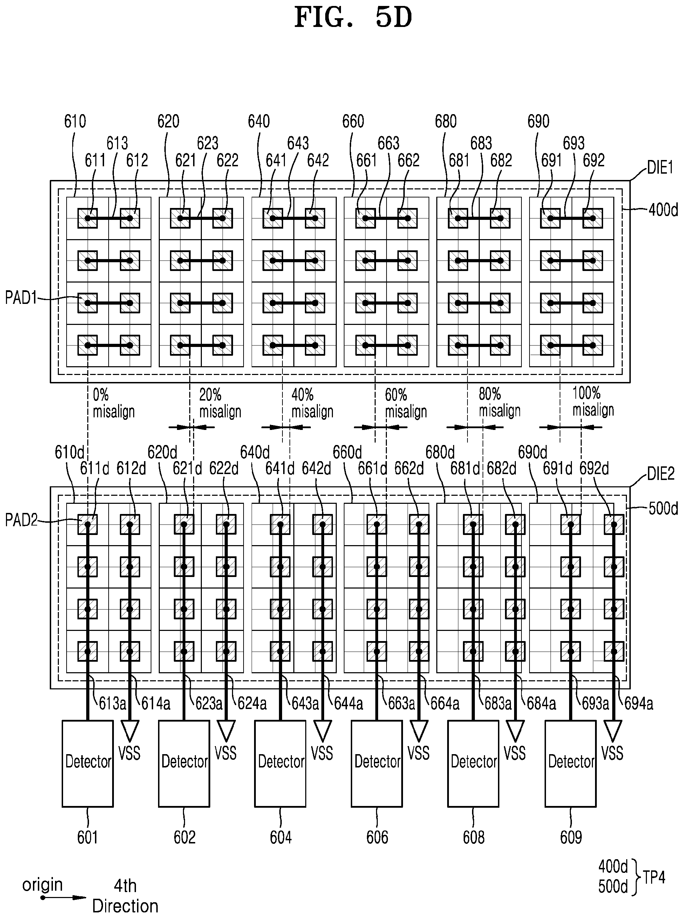

In FIG. 5D, a fourth test pattern TP4 including the first test pad pattern 400d of the first die DIE1 and the second test pad pattern 500d of the second die DIE2 may be different from the first test pattern TP1 of FIG. 5A in that first test pad groups 610 and 610d, second test pad groups 620 and 620d, third test pad groups 640 and 640d, fourth test pad groups 660 and 660d, fifth test pad groups 680 and 680d, and sixth test pad groups 690 and 690d may be designed to have 0%, 20%, 40%, 60%, 80%, and 100% misalignment shapes, respectively, in a fourth direction with respect to the origin point, that is, the difference between corresponding two of the misalignment shapes is 20%.

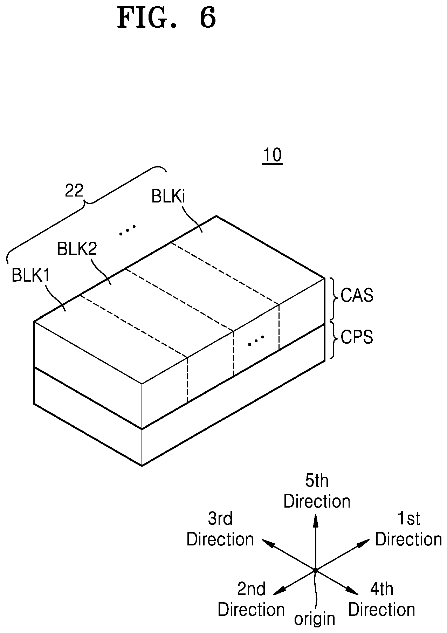

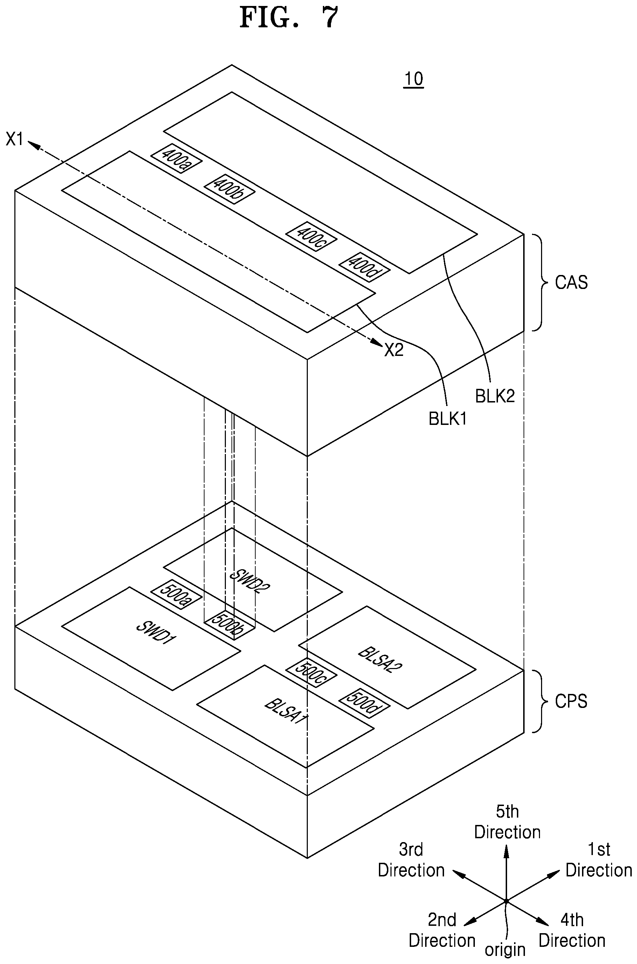

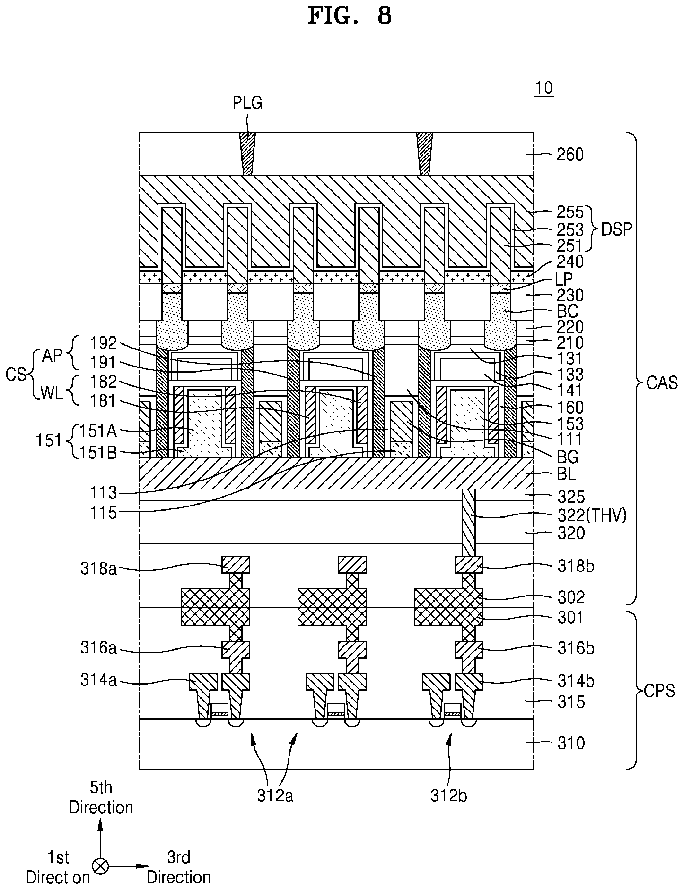

FIGS. 6 to 9 are views to describe an example of a semiconductor device according to some implementations. FIGS. 6, 7, and 9 depict structures of a memory device 10 in which the first die DIE1 and the second die DIE2 of FIG. 2 are coupled to each other. FIG. 8 is a cross-sectional view of the memory device 10, taken along a line X1-X2 of FIG. 7. The memory device 10 may include DRAM including a plurality of memory cells including a vertical channel transistor and a capacitor. For convenience of understanding, elements described as an upper/lower surface, an upper/lower portion, above/below, right/left, etc. are based on directions illustrated in the drawings referred to. Accordingly, the same surface may be referred to as either of an upper surface and a lower surface, depending on the direction illustrated in the drawing.

In FIG. 6, the memory device 10 may include a cell array structure CAS and a core peripheral circuit structure CPS overlapping each other in a vertical direction (a fifth direction). The cell array structure CAS may include a memory cell array 22 formed on an upper substrate (for example, 320 of FIG. 8), and the core peripheral circuit structure CPS may include a core peripheral circuit formed on a lower substrate (for example, 310 of FIG. 8). The cell array structure CAS may include a plurality of memory blocks, namely, first to i^{th} memory blocks BLK1, BLK2, ..., and BLKi (i is a positive integer). The plurality of memory blocks BLK1, BLK2, ..., and BLKi may include a plurality of memory cells including a vertical channel transistor and a capacitor. The core peripheral circuit of the core peripheral circuit structure CPS may be formed by including, on the lower substrate, semiconductor devices, such as a transistor, and a pattern for interconnecting the semiconductor devices. The core peripheral circuit may include peripheral circuits including a row decoder and a sense amplifier. The row decoder may include word line driver circuits configured to decode a row address and select a word line WL corresponding to the row address and apply a word line driving voltage having a high voltage level to the selected word line WL. The sense amplifier may be configured to sense a voltage level of bit lines BL corresponding to a column address from among bit lines BL of the memory cells connected to the selected word line WL. Patterns (for example, bonding metal pads 301 and 302 of FIG. 8) may be formed for electrically connecting the word lines WL and the bit lines BL of the memory cell array 22 with the core peripheral circuit formed in the core peripheral circuit structure CPS.

In FIG. 7, the cell array structure CAS may include the first memory block BLK1 and the second memory block BLK2, and the first test pad patterns 400a, 400b, 400c, and 400d described with reference to FIGS. 5A to 5D may be arranged between the first memory block BLK1 and the second memory block BLK2. The core peripheral circuit structure CPS may include, in an area overlapping the first memory block BLK1, a first word line driver circuit SWD1 and a first bit line sense amplifier circuit BLSA1 respectively connected to the word lines WL and the bit lines BL of the first memory block BLK1 and may include, in an area overlapping the second memory block BLK2, a second word line driver circuit SWD2 and a second bit line sense amplifier circuit BLSA2 respectively connected to the word lines WL and the bit lines BL of the second memory block BLK2. The second test pad patterns 500a, 500b, 500c, and 500d described with reference to FIGS. 5A to 5D may be arranged between the first word line driver circuit SWD1 and the first bit line sense amplifier circuit BLSA1 and the second word line driver circuit SWD2 and the second bit line sense amplifier circuit BLSA2.

In FIG. 8, the core peripheral circuit structure CPS may include the lower substrate 310, an interlayer insulating layer 315, a plurality of circuit elements, namely, first and second circuit elements 312a and 312b, formed on the lower substrate 310, first metal layers 314a and 314b respectively connected to the plurality of circuit elements, namely, the first and second circuit elements 312a and 312b, second metal layers 316a and 316b formed on the first metal layers 314a and 314b, and the bonding metal pad 301 formed on an uppermost metal layer of the core peripheral circuit structure CPS. According to some implementations, the first metal layers 314a and 314b may include tungsten (W) having relatively high resistance, the second metal layers 316a and 316b may include copper (Cu) having relatively low resistance, and the bonding metal pad 301 may include Cu. According to some implementations, the bonding metal pad 301 may include aluminum (Al) or W.

In the present disclosure, only the first metal layers 314a and 314b and the second metal layers 316a and 316b are illustrated and described. However, the present disclosure is not limited thereto, and one or more metal layers may further be formed on the second metal layers 316a and 316b. At least one of the one or more metal layers formed above the second metal layers 316a and 316b may include aluminum, etc. having a lower resistance than Cu included in the second metal layers 316a and 316b. The interlayer insulating layer 315 may be arranged on the lower substrate 310 to cover the plurality of circuit elements, namely, the first and second circuit elements 312a and 312b, the first metal layers 314a and 314b, and the second metal layers 316a and 316b and may include an insulating material, such as silicon oxide, silicon nitride, etc.

The plurality of circuit elements, namely, the first and second circuit elements 312a and 312b, may be connected to at least one of the circuit elements included in the peripheral circuits. For convenience of explanation, the first circuit element 312a may indicate transistors included in the first word line driver circuit SWD1, and the second circuit element 312b may indicate transistors included in the first bit line sense amplifier circuit BLSA1.

In the memory device 10, the bit lines BL may be arranged on the upper substrate 320 and apart from each other in a first direction. In one example, a layer 325 may be located between the bit line BL and the upper substrate 320. The upper substrate 320 may refer to an element corresponding to the lower substrate 310. According to some implementations, the upper substrate 320 may be referred to as a plate or a conductive plate. The bit lines BL may be apart from each other in the first direction and may extend in a third direction crossing (transversing) the first direction. Active patterns AP may be alternately arranged on each of the bit lines BL in the third direction. The active patterns AP may be apart from each other by a certain distance in the first direction. That is, the active patterns AP may be two-dimensionally arranged in the first direction and the third direction crossing each other. According to some embodiments, the plurality of word lines WL, the plurality of bit lines BL, and the plurality of active patterns AP may form a plurality of vertical channel transistors.

Each of the active patterns AP may have a length in the first direction, a width in the third direction, and a height in the fifth direction perpendicular to the upper substrate 320. Each of the active patterns AP may have substantially the same width. Each of the active patterns AP may have an upper surface and a lower surface opposite to each other in the fifth direction. For example, the lower surfaces of the active patterns AP may be in contact with the bit line BL. Each of the active patterns AP may include a source area, which is adjacent to the bit line BL, a drain area, which is adjacent to a contact pattern BC, and a channel area, which is between the source area and the drain area. The channel areas of the active patterns AP may be controlled by the word lines WL and back gate electrodes BG during an operation of the memory device 10. The active patterns AP may include, for example, monocrystalline silicon (Si), in order to improve the leakage current characteristic during the operation of the memory device 10.

The back gate electrodes BG may be arranged on the bit lines BL and apart from each other by a certain distance in the third direction. The back gate electrodes BG may extend in the first direction across the bit lines BL. Each of the back gate electrodes BG may be arranged between the active patterns AP adjacent to each other in the third direction. A first active pattern 191 may be arranged at a side of each of the back gate electrodes BG, and a second active pattern 192 may be arranged at the other side. The back gate electrodes BG may have a less height than the active patterns AP in a vertical direction (i.e., the fifth direction). The back gate electrodes BG may receive a negative voltage during an operation of the memory device 10 and may increase a threshold voltage of the vertical channel transistor. Accordingly, it is possible to prevent deterioration of the leakage current characteristic, due to reduction of a threshold voltage, according to a fine structure of the vertical channel transistor.

A first insulating pattern 111 may be arranged between the active patterns AP adjacent to each other in a third direction. The first insulating pattern 111 may extend in the first direction in parallel with the back gate electrodes BG. A back gate insulating layer 113 may be arranged between each back gate electrode BG and each active pattern AP and between the back gate electrode BG and the first insulating pattern 111. The back gate insulating layer 113 may include vertical portions covering both side surfaces of the back gate electrode BG and a horizontal portion connecting the vertical portions. The horizontal portion of the back gate insulating layer 113 may be adjacent to the contact pattern BC more than to the bit line BL and may cover an upper surface of the back gate electrode BG. A back gate capping pattern 115 may be arranged between the bit lines BL and the back gate electrode BG. The back gate capping pattern 115 may include an insulating material, and a lower surface of the back gate capping pattern 115 may be in contact with the bit lines BL. The back gate capping pattern 115 may be arranged between the vertical portions of the back gate insulating layer 113.

The word lines WL may extend on the bit lines BL in the first direction and may be alternately arranged in the third direction. A first word line 181 from among the word lines WL may be arranged at a side of the first active pattern 191, and a second word line 182 from among the word lines WL may be arranged at the other side of the second active pattern 192. A portion of the first word lines 181 may be arranged between the first active patterns 191 adjacent to each other in the first direction, and a portion of the second word lines 182 may be arranged between the second active patterns 192 adjacent to each other in the first direction.

The word lines WL may be vertically apart from the bit lines BL and the contact patterns BC. From the vertical perspective, the word lines WL may be arranged between the bit lines BL and the contact patterns BC. The word lines WL adjacent to each other may have side walls facing each other. The word lines WL may have a less height than the active patterns AP in the vertical direction. The height of the word lines WL may be the same as or greater than the height of the back gate electrodes BG in the third direction.

Gate insulating layers 160 may be arranged between the word lines WL and the active patterns AP. The gate insulating layers 160 may extend in the first direction in parallel with the word lines WL. The gate insulating layer 160 may cover a side surface of the first active pattern 191 and the other surface (e.g., the other side surface) of the second active pattern 192. The gate insulating layers 160 may have substantially the same thickness. A second insulating pattern 141 may be arranged between the gate insulating layer 160 and the contact patterns BC. For example, the second insulating pattern 141 may include silicon oxide. A first etch stop layer 131 and a second etch stop layer 133 may be arranged between the active patterns AP and the second insulating pattern 141.

The word lines WL may be separated from each other by a third insulating pattern 151 on the bit line BL. The third insulating pattern 151 may extend in the first direction between the word lines WL. A first capping layer 153 may be arranged between the third insulating pattern 151 and the word lines WL. The first capping layers 153 may have substantially the same thickness. The third insulating pattern 151 may include a third vertical pattern 151A and a third horizontal pattern 151B.

The contact patterns BC may pass through a third etch stop layer 210 and an interlayer insulating layer 220 and may be in contact with the active patterns AP, respectively. In other words, the contact patterns BC may be in contact with the drain areas of the active patterns AP, respectively. A lower width of the contact patterns BC may be greater than an upper width of the contact patterns BC. The contact patterns BC adjacent to each other may be separated from each other by isolation insulating patterns 230. Each of the contact patterns BC may have various shapes, such as a circular shape, an oval shape, a rectangular shape, a square shape, a diamond shape, a hexagonal shape, etc. in the planar perspective. Landing pads LP may be arranged on the contact patterns BC.

The isolation insulating patterns 230 may be arranged between the landing pads LP. In the planar perspective, the landing pads LP may be arranged in a matrix shape in the first direction and the third direction. Upper surfaces of the landing pads LP may be substantially coplanar with upper surfaces of the isolation insulating patterns 230. A fourth etch stop layer 240 may be formed on the isolation insulating patterns 230.

Data storage patterns DSP may be arranged on the landing pads LP. The data storage patterns DSP may be electrically connected to the active patterns AP, respectively. The data storage patterns DSP may be arranged in a matrix shape in the first direction and the third direction. The data storage patterns DSP may completely overlap or partially overlap the landing pads LP. The data storage patterns DSP may be in contact with the entire upper surface or a partial upper surface of the landing pads LP. An upper insulating layer 260 may be arranged on the data storage patterns DSP, and cell contact plugs PLG may be in contact with a plate electrode 255 by passing through the upper insulating layer 260.

According to some implementations, the data storage patterns DSP may correspond to the cell capacitor and may include a capacitor dielectric layer 253 arranged between storage electrodes 251 and the plate electrode 255. In this case, the storage electrode 251 may be directly in contact with the landing pad LP, and the storage electrode 251 may have various shapes, such as a circular shape, an oval shape, a rectangular shape, a square shape, a diamond shape, a hexagonal shape, etc. in the planar perspective.

According to some implementations, the data storage patterns DSP may be variable resistance patterns which may be switched between two resistance states according to an electrical pulse applied to a memory element. For example, the data storage patterns DSP may include a phase-change material having a crystalline state changing according to the amount of current, a perovskite compound, a transition metal oxide, a magnetic material, a ferromagnetic material, an antiferromagnetic material, etc. but are not limited thereto. According to a material layer of the data storage patterns DSP, the memory device 10 may be realized as a resistive memory, such as PRAM, MRAM, RRAM, etc.

A through electrode (THV) 322 may be in contact with a metal layer 318b by passing through the upper substrate 320 and may extend lengthwise in the fifth direction up to the bonding metal pad 302 formed on the uppermost metal layer of the core peripheral circuit structure CPS. According to some implementations, only the metal layers 318a and 318b are illustrated and described. However, the present disclosure is not limited thereto, and one or more metal layers may further be formed on the metal layers 318a and 318b. The bit lines BL may be electrically connected to the second circuit element 312b of the first bit line sense amplifier circuit BLSA1 through the bonding metal pad 302 of the cell array structure CAS and the bonding metal pad 301 of the core peripheral circuit structure CPS.

According to some implementations, the bonding metal pad 302 of the cell array structure CAS and the bonding metal pad 301 of the core peripheral circuit structure CPS may be connected to each other by an electrical or a physical bonding method. When the bonding metal pads 301 and 302 include Cu, the bonding method may be a Cu-Cu bonding method. As another example, the bonding metal pads 301 and 302 may also include A1 or W.

Each of the word lines WL may be electrically or physically connected to the metal layer 318a of the cell array structure CAS, and the metal layer 318a of the cell array structure CAS may be in contact with the bonding metal pad 301. Each of the word lines WL may be electrically connected to the first circuit element 312a of the first word line driver circuit SWDI1 through the bonding metal pad 302 of the cell array structure CAS and the bonding metal pad 301 of the core peripheral circuit structure CPS. Each of the bit lines BL may be electrically or physically connected to the metal layer 318b of the cell array structure CAS, and the metal layer 318a of the cell array structure CAS may be in contact with the bonding metal pad 301. Each of the bit lines BL may be electrically connected to the second circuit element 312b of the first bit line sense amplifier circuit BLSA1 through the bonding metal pad 302 of the cell array structure CAS and the bonding metal pad 301 of the core peripheral circuit structure CPS.

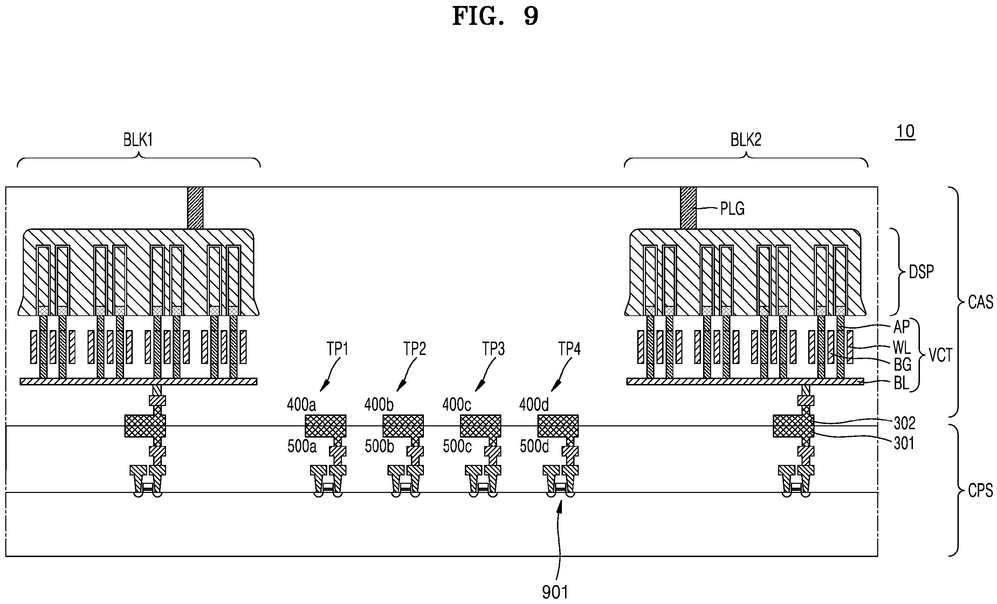

In FIG. 9, in the memory device 10, the memory cells including the data storage pattern DSP, the word line WL, the back gate electrode BG, the active pattern AP, and the bit line BL may be arranged in each of an area of the first memory block BLK1 and an area of the second memory block BLK2 of the cell array structure CAS. The word line WL, the active pattern AP, and the bit line BL may form a vertical channel transistor VCT. In a process of forming the bonding metal pad 302 of the cell array structure CAS, the first test pad patterns 400a, 400b, 400c, and 400d of the first to fourth test patterns TP1 to TP4 described with reference to FIGS. 5A to 5D may be formed. In a process of forming the bonding metal pad 301 of the core peripheral circuit structure CPS, the second test pad patterns 500a, 500b, 500c, and 500d of the first to fourth test patterns TP1 to TP4 described with reference to FIGS. 5A to 5D may be formed. Each of the second test pad patterns 500a to 500d may be connected to a detector 901, and the detector 901 may detect whether or not test pads of the first to sixth test pad groups 610 and 610b, 620 and 620b, 640 and 640b, 660 and 660b, 680 and 680b, and 690 and 690b are misaligned.

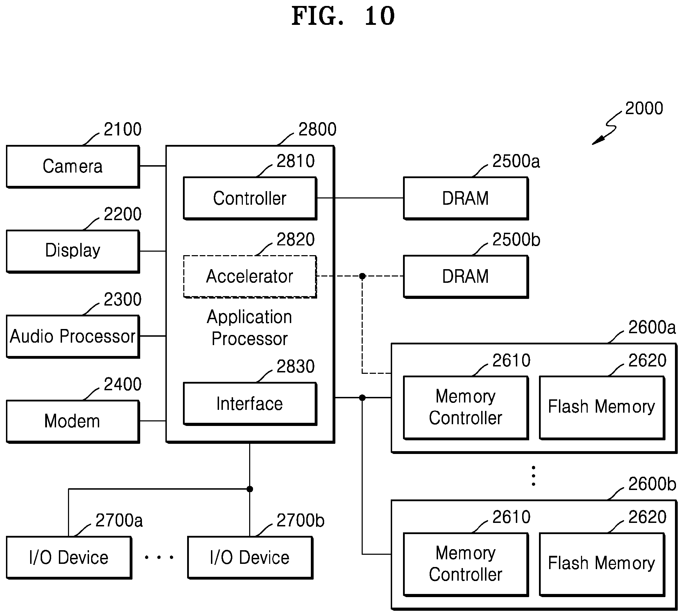

FIG. 10 is a block diagram of an example of a system of an electronic device including a semiconductor device according to some implementations. In FIG. 10, a system 2000 may include a camera 2100, a display 2200, an audio processor 2300, a modem 2400, dynamic random-access memories (DRAMs) 2500a and 2500b, flash memories 2600a and 2600b, input/output (I/O) devices 2700a and 2700b, and an application processor (AP) 2800. The system 2000 may be implemented by a laptop computer, a mobile terminal, a smartphone, a table personal computer (PC), a wearable device, a health care device, or an Internet of Things (IoT) device. Also, the system 2000 may be implemented by a server or a PC.

The camera 2100 may capture a still image or a video, store the captured image/video data, or transmit the captured image/video data to the display 2200, according to control by a user. The audio processor 2300 may process audio data included in the contents of the flash memories 2600a and 2600b or networks. The modem 2400 may modulate and transmit a signal for transmission and reception of wired/wireless data, and a receiving end may demodulate the signal to restore the original signal. The I/O devices 2700a and 2700b may include devices for providing a digital input and/or output function, such as a universal serial bus (USB), a storage, a digital camera, a secure digital (SD) card, a digital versatile disc (DVD), a network adapter, a touch screen, etc.

The AP 2800 may control general operations of the system 2000. The AP 2800 may include a control block 2810, an accelerator block or an accelerator chip 2820, and an interface block 2830. The AP 2800 may control the display 2200 to display a portion of the contents stored in the flash memories 2600a and 2600b. When a user input is received through the I/O devices 2700a and 2700b, the AP 2800 may perform a control operation corresponding to the user input. The AP 2800 may include an accelerator block, which is an exclusive circuit for artificial intelligence (AI) data calculation, or an accelerator chip 2820 may be separately provided from the AP 2800. The DRAM 2500b may be additionally mounted in the accelerator block or the accelerator chip 2820. The accelerator may be a functional block specialized in a specific function of the AP 2800 and may include a GPU, which is a functional block specialized in graphics data processing, a neural processing unit (NPU), which is a block specialized in AI calculations and inference, and a data processing unit (DPU), which is a block specialized in data transmission. According to some implementations, an image captured by a user by using the camera 2100 may be signal processed and stored in the DRAM 2500b, and the accelerator block or the accelerator chip 2820 may perform AI data calculation for recognizing data by using data stored in the DRAM 2500b and the function for inference.

The system 2000 may include the plurality of DRAMs 2500a and 2500b. The AP 2800 may control the DRAMs 2500a and 2500b according to a command and an MRS complying with the JEDEC standards or may perform communication by setting a DRAM interface regulation to use a business-exclusive function related to low voltage/high speed/reliability and a cyclic redundancy check (CRC)/error correction code (ECC) function. For example, the AP 2800 may communicate with the DRAM 2500a by using an interface according to the JEDEC standards, such as LPDDR4, LPDDR5, etc., and may communicate with the DRAM 2500b by setting a new DRAM interface regulation to control the DRAM 2500b for the accelerator that has a greater bandwidth than the DRAM 2500a.

FIG. 10 depicts only the DRAMs 2500a and 2500b. However, the present disclosure is not limited thereto, and any one of the memories, such as PRAM, SRAM, MRAM, RRAM, FRAM, or hybrid random-access memory (RAM), that satisfies conditions about a bandwidth, a response rate, and a voltage with respect to the AP 2800 or the accelerator chip 2820, may be used. The DRAMs 2500a and 2500b may have a relatively less latency and a relatively less bandwidth than the I/O devices 2700a and 2700b or the flash memories 2600a and 2600b. The DRAMs 2500a and 2500b may be initialized at a power on time point of the system 2000, and loaded with an operating system and application data, the DRAMs 2500a and 2500b may be used as a temporary storage of the operating system and the application data or as an execution space of various software codes.

In the DRAMs 2500a and 2500b, the four fundamental arithmetic operations of addition/subtraction/multiplication/division, a vector operation, an address operation, or a fast Fourier transform (FET) operation may be performed. Also, in the DRAMs 2500a and 2500b, a function for inference may be performed. Here, the inference may be performed by a deep learning algorithm using an artificial neural network. The deep learning algorithm may include a training operation in which a model is trained by using various data and an inference operation in which the trained model recognizes data.

The system 2000 may include a plurality of storages or the plurality of flash memories 2600a and 2600b having greater capacities than the DRAMs 2500a and 2500b. The accelerator block or the accelerator chip 2820 may perform the training operation and the AI data calculation by using the flash memories 2600a and 2600b. According to some implementations, the flash memories 2600a and 2600b may include a memory controller 2610 and a flash memory device 2620 and may use an operation device provided in the memory controller 2610 to perform, with relatively increased efficiency, the training operation and the inference AI data calculation performed by the AP 2800 and/or the accelerator chip 2820. The flash memories 2600a and 2600b may store a photograph captured by the camera 2100 or store data transmitted from a data network. For example, augmented reality (AR)/virtual reality (VR), high definition (HD), or ultra-high definition (UHD) contents may be stored.

The components of the system 2000 may include test pad patterns configured to detect misalignment of the chip bonding pads described with reference to FIGS. 1 to 9. First test pad patterns including first test pads may be included in a first semiconductor die, and second test pad patterns including second test pads may be included in a second semiconductor die. The first test pads of each of first test pad groups of the first semiconductor die may be electrically connected to each other through a line extending in a first direction, and the second test pads of each of second test pad groups of the second semiconductor die may be electrically connected to each other through a line extending in a third direction and crossing the first direction. In each of the first test pad groups and each of the second test pad groups, various misalignment patterns may be arranged between the first test pads and the second test pads. A detector configured to determine the degree of alignment accuracy when the first semiconductor die is coupled to the second semiconductor die, may include a switch configured to apply a power voltage of the second semiconductor die to the second test pads electrically connected to each other through a first line in the third direction and apply a ground voltage to the second test pads electrically connected to each other through a second line extending in the third direction, with respect to each of the second test pad groups. The detector may detect, based on currents flowing between the first test pads of each of the first test pad groups and the second test pads of each of the second test pad groups, misalignment between the first semiconductor die and the second semiconductor die. Based on the detected misalignment, the detector may be configured to correct the misalignment during the coupling of the first semiconductor die and the second semiconductor die. For example, the detector may be configured to implement or instruct one or more error correction algorithms to correct and/or mitigate the effects of the misalignment. The detector may be configured to adjust placement of the pads based on the determined misalignment to correct the misalignment.

According to an aspect of the present disclosure, a semiconductor wafer includes a first semiconductor wafer, a second semiconductor wafer and a detector. The first semiconductor wafer includes first semiconductor dies arranged in a first direction and a third direction traversing the first direction, wherein each of the first semiconductor dies includes a plurality of first bonding metal pad groups that each includes first bonding metal pads and a plurality of first test pad groups that each includes first test pads, the first bonding metal pads of each of the plurality of first bonding metal pad groups are connected to a cell array structure including a plurality of memory blocks, and the first test pads of each of the plurality of first test pad groups are electrically connected to each other through a line extending in the first direction. The second semiconductor wafer includes second semiconductor dies arranged in the first direction and the third direction, wherein each of the second semiconductor dies includes a plurality of second bonding metal pad groups that each includes second bonding metal pads respectively in contact with the first bonding metal pads and a plurality of second test pad groups that each includes second test pads, the second bonding metal pads are connected to a core peripheral circuit structure including circuits respectively connected to the plurality of memory blocks, the plurality of second test pad groups are arranged at positions respectively corresponding to positions of the plurality of first test pad groups, and the second test pads of each of the plurality of second test pad groups are electrically connected to each other through a line extending in the third direction . The detector is configured to determine a degree of accuracy in alignment between the first semiconductor wafer and the second semiconductor wafer, based on current flowing between the first test pads of each of the plurality of first test pad groups and the second test pads of each of the plurality of second test pad groups, with the first semiconductor wafer and the second semiconductor wafer being coupled to each other.

In some embodiments, each of the plurality of first test pad groups is arranged between the plurality of memory blocks, and each of the plurality of second test pad groups is arranged between word line driver circuits of the second semiconductor die that are respectively connected to a plurality of word lines of each of the plurality of memory blocks.

In some embodiments, the second bonding metal pads are connected to bit line sense amplifier circuits of the second semiconductor die that are respectively connected to a plurality of bit lines of each of the plurality of memory blocks, and each of the plurality of second test pad groups is arranged between the bit line sense amplifier circuits respectively corresponding to the plurality of memory blocks.

In some embodiments, each of the plurality of first test pad groups and each of the plurality of second test pad groups are arranged with misalignment patterns being arranged between the first test pads and the second test pads.

In some embodiments, a size of the misalignment patterns increases in the first direction and bonding areas between the first test pads and the second test pads decrease.

In some embodiments, a size of the misalignment patterns increases in a second direction that is opposite to the first direction and bonding areas between the first test pads and the second test pads decrease.

In some embodiments, a size of the misalignment patterns increases in the third direction and bonding areas between the first test pads and the second test pads decrease.

In some embodiments, a size of the misalignment patterns increases in a fourth direction that is opposite to the third direction and bonding areas between the first test pads and the second test pads decrease.

In some embodiments, the detector is included in the second semiconductor die. The detector includes a switch configured to apply a power voltage of the second semiconductor die to the second test pads electrically connected to each other through a first line extending in the third direction and apply a ground voltage to the second test pads electrically connected to each other through a second line extending in the third direction, with respect to each of the plurality of second test pad groups.

In some embodiments, the detector is configured to adjust misalignment which is obtained based on the determined degree in accuracy of alignment with the first semiconductor wafer and the second semiconductor wafer being coupled to each other.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following clauses:
Clause 1: A semiconductor die comprising:
   a first semiconductor die comprising a plurality of first test pad groups that each includes first test pads, wherein the first test pads of each of the plurality of first test pad groups are electrically connected to each other through a line extending in a first direction;
   a second semiconductor die comprising a plurality of second test pad groups that each includes second test pads, wherein the plurality of second test pad groups are arranged at positions respectively corresponding to positions of the plurality of first test pad groups, and the second test pads of each of the plurality of second test pad groups are electrically connected to each other through a line extending in a third direction that transverses the first direction; and
   a detector configured to determine a degree of accuracy in alignment between the first semiconductor die and the second semiconductor die, based on current flowing between the first test pads of each of the plurality of first test pad groups and the second test pads of each of the plurality of second test pad groups, with the first semiconductor die and the second semiconductor die being coupled to each other.
Clause 2: The semiconductor die of clause 1, wherein each of the plurality of first test pad groups and each of the plurality of second test pad groups are arranged with misalignment patterns being arranged between the first test pads and the second test pads.
Clause 3: The semiconductor die of clause 2, wherein a size of the misalignment patterns increases in the first direction and bonding areas between the first test pads and the second test pads decrease.
Clause 4: The semiconductor die of clause 2, wherein a size of the misalignment patterns increases in a second direction that is opposite to the first direction and bonding areas between the first test pads and the second test pads decrease.
Clause 5: The semiconductor die of clause 2, wherein a size of the misalignment patterns increases in the third direction and bonding areas between the first test pads and the second test pads decrease.
Clause 6: The semiconductor die of clause 2, wherein a size of the misalignment patterns increases in a fourth direction that is opposite to the third direction and bonding areas between the first test pads and the second test pads decrease.
Clause 7: The semiconductor die of any preceding clause,
   wherein the detector is included in the second semiconductor die, and
   wherein the detector comprises a switch configured to apply a power voltage of the second semiconductor die to the second test pads electrically connected to each other through a first line extending in the third direction, and apply a ground voltage to the second test pads electrically connected to each other through a second line extending in the third direction, with respect to each of the plurality of second test pad groups.
Clause 8: The semiconductor die of any preceding clause, wherein the detector is configured to adjust misalignment which is obtained based on the determined degree of accuracy in alignment with the first semiconductor die and the second semiconductor die being coupled to each other.
Clause 9: A semiconductor die comprising:
   a first semiconductor die comprising first bonding metal pads and a plurality of first test pad groups that each includes first test pads, wherein the first bonding metal pads are connected to a cell array structure comprising a plurality of memory blocks, and the first test pads of each of the plurality of first test pad groups are electrically connected to each other through a line extending in a first direction;
   a second semiconductor die comprising second bonding metal pads in contact with the first bonding metal pads, respectively, and a plurality of second test pad groups that each includes second test pads, wherein the second bonding metal pads are connected to a core peripheral circuit structure comprising circuits connected to the plurality of memory blocks, respectively, and wherein the plurality of second test pad groups are arranged at positions respectively corresponding to positions of the plurality of first test pad groups, and the second test pads of each of the plurality of second test pad groups are electrically connected to each other through a line extending in a third direction that transverses the first direction; and
   a detector configured to determine a degree of accuracy in alignment between the first semiconductor die and the second semiconductor die, based on current flowing between the first test pads of each of the plurality of first test pad groups and the second test pads of each of the plurality of second test pad groups, with the first semiconductor die and the second semiconductor die being coupled to each other.
Clause 10: The semiconductor die of clause 9,
   wherein each of the plurality of first test pad groups is arranged between the plurality of memory blocks, and
   wherein each of the plurality of second test pad groups is arranged between word line driver circuits of the second semiconductor die that are respectively connected to a plurality of word lines of each of the plurality of memory blocks.
Clause 11: The semiconductor die of clause 9 or 10,
   wherein the second bonding metal pads are connected to bit line sense amplifier circuits of the second semiconductor die that are respectively connected to a plurality of bit linesof each of the plurality of memory blocks, and
   wherein each of the plurality of second test pad groups is arranged between the bit line sense amplifier circuits respectively corresponding to the plurality of memory blocks.
Clause 12: The semiconductor die of any of clauses 9 to 11, wherein each of the plurality of first test pad groups and each of the plurality of second test pad groups are arranged with misalignment patterns being arranged between the first test pads and the second test pads.
Clause 13: The semiconductor die of clause 12, wherein a size of the misalignment patterns increases in the first direction and bonding areas between the first test pads and the second test pads decrease.
Clause 14: The semiconductor die of clause 12, wherein a size of the misalignment patterns increases in a second direction that is opposite to the first direction and bonding areas between the first test pads and the second test pads decrease.
Clause 15: The semiconductor die of clause 12, wherein a size of the misalignment patterns increases in the third direction and bonding areas between the first test pads and the second test pads decrease.

## Claims

1. A semiconductor device comprising:
a first semiconductor die (DIE1) comprising a plurality of first test pad groups (410, 420, 440, 460, 480, 490) that each includes first test pads (411, 412, 421, 422, 441, 442, 461, 462, 481, 482, 491, 492), wherein the first test pads (411, 412, 421, 422, 441, 442, 461, 462, 481, 482, 491, 492) of each of the plurality of first test pad groups (410, 420, 440, 460, 480, 490) are electrically connected to each other through a line (413, 423, 443, 463, 483, 493) extending in a first direction;
a second semiconductor die (DIE2) comprising a plurality of second test pad groups (510, 520, 540, 560, 580, 590) that each includes second test pads (511, 512, 521, 522, 541, 542, 561, 562, 581, 582, 591, 592), wherein the plurality of second test pad groups (510, 520, 540, 560, 580, 590) are arranged at positions respectively corresponding to positions of the plurality of first test pad groups (410, 420, 440, 460, 480, 490), and the second test pads (511, 512, 521, 522, 541, 542, 561, 562, 581, 582, 591, 592) of each of the plurality of second test pad groups (510, 520, 540, 560, 580, 590) are electrically connected to each other through a line (513, 514, 523, 524, 543, 544, 563, 564, 583, 584, 593, 594) extending in a third direction that transverses the first direction; and
a detector (585) configured to determine a degree of accuracy in alignment between the first semiconductor die (DIE1) and the second semiconductor die (DIE2), based on current flowing between the first test pads (411, 412, 421, 422, 441, 442, 461, 462, 481, 482, 491, 492) of each of the plurality of first test pad groups (410, 420, 440, 460, 480, 490) and the second test pads (511, 512, 521, 522, 541, 542, 561, 562, 581, 582, 591, 592) of each of the plurality of second test pad groups (510, 520, 540, 560, 580, 590), with the first semiconductor die (DIE1) and the second semiconductor die (DIE2) being coupled to each other.

2. The semiconductor device of claim 1, wherein each of the plurality of first test pad groups (410, 420, 440, 460, 480, 490) and each of the plurality of second test pad groups (510, 520, 540, 560, 580, 590) are arranged with misalignment patterns being arranged between the first test pads (411, 412, 421, 422, 441, 442, 461, 462, 481, 482, 491, 492) and the second test pads (511, 512, 521, 522, 541, 542, 561, 562, 581, 582, 591, 592).

3. The semiconductor device of claim 2, wherein a size of the misalignment patterns increases in the first direction and bonding areas between the first test pads (411, 412, 421, 422, 441, 442, 461, 462, 481, 482, 491, 492) and the second test pads (511, 512, 521, 522, 541, 542, 561, 562, 581, 582, 591, 592) decrease.

4. The semiconductor device of claim 2, wherein a size of the misalignment patterns increases in a second direction that is opposite to the first direction and bonding areas between the first test pads (411, 412, 421, 422, 441, 442, 461, 462, 481, 482, 491, 492) and the second test pads (511, 512, 521, 522, 541, 542, 561, 562, 581, 582, 591, 592) decrease.

5. The semiconductor device of claim 2, wherein a size of the misalignment patterns increases in the third direction and bonding areas between the first test pads (411, 412, 421, 422, 441, 442, 461, 462, 481, 482, 491, 492) and the second test pads (511, 512, 521, 522, 541, 542, 561, 562, 581, 582, 591, 592) decrease.

6. The semiconductor device of claim 2, wherein a size of the misalignment patterns increases in a fourth direction that is opposite to the third direction and bonding areas between the first test pads (411, 412, 421, 422, 441, 442, 461, 462, 481, 482, 491, 492) and the second test pads (511, 512, 521, 522, 541, 542, 561, 562, 581, 582, 591, 592) decrease.

7. The semiconductor device of any preceding claim,
wherein the detector (585) is included in the second semiconductor die (DIE2), and
wherein the detector (585) comprises a switch (502) configured to apply a power voltage (VEXT_P) of the second semiconductor die (DIE2) to the second test pads (511, 512, 521, 522, 541, 542, 561, 562, 581, 582, 591, 592) electrically connected to each other through a first line (513, 523, 543, 563, 583, 593) extending in the third direction, and apply a ground voltage (VSS) to the second test pads (511, 512, 521, 522, 541, 542, 561, 562, 581, 582, 591, 592) electrically connected to each other through a second line (514, 524, 544, 564, 584, 594) extending in the third direction, with respect to each of the plurality of second test pad groups (510, 520, 540, 560, 580, 590).

8. The semiconductor device of any preceding claim, wherein the detector (585) is configured to adjust misalignment which is obtained based on the determined degree of accuracy in alignment with the first semiconductor die (DIE1) and the second semiconductor die (DIE2) being coupled to each other.

9. The semiconductor of claim 1, wherein:
the first semiconductor die (DIE1) further comprises first bonding metal pads (301), wherein the first bonding metal pads (301) are connected to a cell array structure (CAS) comprising a plurality of memory blocks (BLK1, BLK2);
the second semiconductor die (DIE2) further comprises second bonding metal pads (302) in contact with the first bonding metal pads (301), respectively, wherein the second bonding metal pads (302) are connected to a core peripheral circuit structure (CPS) comprising circuits connected to the plurality of memory blocks (BLK1, BLK2), respectively.

10. The semiconductor device of claim 9,
wherein each of the plurality of first test pad groups (410, 420, 440, 460, 480, 490) is arranged between the plurality of memory blocks (BLK1, BLK2), and
wherein each of the plurality of second test pad groups (510, 520, 540, 560, 580, 590) is arranged between word line driver circuits (SWD1, SWD2) of the second semiconductor die (DIE2) that are respectively connected to a plurality of word lines (WL) of each of the plurality of memory blocks (BLK1, BLK2).

11. The semiconductor device of claim 9 or 10,
wherein the second bonding metal pads (302) are connected to bit line sense amplifier circuits (BLSA1, BLSA2) of the second semiconductor die (DIE2) that are respectively connected to a plurality of bit lines (BL) of each of the plurality of memory blocks (BLK1, BLK2), and
wherein each of the plurality of second test pad groups (510, 520, 540, 560, 580, 590) is arranged between the bit line sense amplifier circuits (BLSA1, BLSA2) respectively corresponding to the plurality of memory blocks (BLK1, BLK2).

12. The semiconductor device of any of claims 9 to 11, wherein each of the plurality of first test pad groups (410, 420, 440, 460, 480, 490) and each of the plurality of second test pad groups (510, 520, 540, 560, 580, 590) are arranged with misalignment patterns being arranged between the first test pads (411, 412, 421, 422, 441, 442, 461, 462, 481, 482, 491, 492) and the second test pads (511, 512, 521, 522, 541, 542, 561, 562, 581, 582, 591, 592).

13. The semiconductor device of claim 12, wherein a size of the misalignment patterns increases in the first direction and bonding areas between the first test pads and the second test pads (511, 512, 521, 522, 541, 542, 561, 562, 581, 582, 591, 592) decrease.

14. The semiconductor device of claim 12, wherein a size of the misalignment patterns increases in a second direction that is opposite to the first direction and bonding areas between the first test pads (411, 412, 421, 422, 441, 442, 461, 462, 481, 482, 491, 492) and the second test pads decrease.

15. The semiconductor device of claim 12, wherein a size of the misalignment patterns increases in the third direction and bonding areas between the first test pads (411, 412, 421, 422, 441, 442, 461, 462, 481, 482, 491, 492) and the second test pads (511, 512, 521, 522, 541, 542, 561, 562, 581, 582, 591, 592) decrease.
